# FASCICULE DE BREVET EUROPEEN

(11) **EP 1 187 316 B1**
(45) Date de publication et mention de la délivrance du brevet: **25.06.2008**
(21) Numéro de dépôt: 01402026.7
(22) Date de dépôt: 26.07.2001
(51) Int. Cl.: H03G 3/30

(54) **Procédé et circuit de contrôle permettant l'utilisation d'un amplificateur de puissance en technologie HBT dans un émetteur en architecture à fréquence intermédiaire nulle**
Verfahren und Steuerungsschaltung zur Verwendung eines Leistungsverstärkers in Heteroübergangs-Bipolartransistortechnik in einem Sender in einer Architektur mit Null Hertz Zwischenfrequenz
Method and Control Circuit for Use of a HBT Transistor Power Amplifier in a Transmitter Using Zero IF Architecture

(30) Priorité: 31.08.2000 FR 0011117
(43) Date de publication de la demande: 13.03.2002
(73) Titulaire: TCL & ALCATEL MOBILE PHONES LIMITED, China Hong Kong City, 33 Canton Road, Tsim Sha Tsui,Kowloon, Hong Kong (CN)
(72) Inventeur: Greverie, Franck, 75009 Paris (FR); Renard-d'Arvil, Luc, 95110 Sannois (FR)
(74) Mandataire: Feray, Valérie

(56) Documents cités:
- EP-A- 0 546 693
- EP-A- 0 645 899
- EP-A- 1 014 570
- WO-A-99/17444
- US-A- 5 878 332

## Description

La présente invention concerne le contrôle de l'amplification du signal émis par un terminal de radiocommunication mobile, et plus particulièrement dans le cadre de l'utilisation d'amplificateurs de puissance à transistors HBT.

Afin d'assurer une puissance suffisante lors de la phase d'émission, le signal émis par un terminal tel qu'un téléphone mobile doit être amplifié.

Pour cela, les terminaux disposent d'un amplificateur de puissance recevant une puissance d'entrée et émettant une puissance de sortie amplifiée, l'amplification dépendant de la tension de contrôle alimentant l'amplificateur.

Le document EP-A- 1 014 570 décrit différents circuits de contrôle d'un tel amplificateur de puissance ».

Certains amplificateurs de puissances fonctionnant à partir de transistor en technologie dite « HBT » (pour Heterojunction Bipolar Transistor ou transistor bipolaire à hétérojonction), permettent d'obtenir un rendement supérieur à celui des amplificateurs de puissance utilisant d'autres technoloaies, pour un encombrement bien inférieur.

L'utilisation de transistors HBT dans un amplificateur de puissance est notamment décrite dans les documents WO 99/17444 et US 5, 878, 332.

Dans certains cas, l'architecture de transmission retenue par les constructeurs de terminaux mobiles est une architecture où la fréquence intermédiaire est nulle. Dans ce type d'architecture, permettant une réduction des coûts et de l'encombrement, la conversion d'amplitude liée à l'amplification (ou conversion AM/AM) est un paramètre très important. La dégradation du spectre liée au phénomène de conversion AM/AM est critique dans une architecture à fréquence intermédiaire nulle.

Avec des amplificateurs de puissances utilisant des transistors HBT, cette dégradation est très importante pour des puissances de sortie faibles de l'amplificateur lorsque celui-ci reçoit des puissances importantes en entrée.

Dans ce contexte, la présente invention a pour but de pallier ces inconvénients en proposant un procédé ainsi qu'un circuit permettant d'employer un amplificateur de puissance utilisant des transistors HBT dans une architecture de transmission à fréquence intermédiaire nulle, tout en réduisant les dégradations observables au niveau du spectre.

A cet effet, l'invention a pour objet un procédé de contrôle tel que défini par la revendication 1

L'invention concerne également un émetteur en architecture à fréquence intermédiaire nulle tel que défini par la revendication 2.

Avantageusement, les moyens d'ajustement du niveau de puissance d'entrée de l'amplificateur de puissance comprennent un atténuateur commandable.

Selon une forme particulière de réalisation, le circuit de contrôle comporte préamplificateur à gain variable.

L'invention concerne, en outre, un terminal de radiocommunication comportant un circuit de contrôle de la puissance conforme à l'invention.

L'invention sera mieux comprise à la lumière de la description qui suit, se rapportant à un exemple de réalisation illustratif mais en aucun cas limitatif, en référence aux dessins annexés dans lequel :
- La figure 1 est un diagramme montrant l'évolution de la puissance de sortie d'un amplificateur de puissance en fonction de la puissance d'entrée ;
- La figure 2 est une représentation schématique d'un dispositif apte à mettre en oeuvre l'invention.

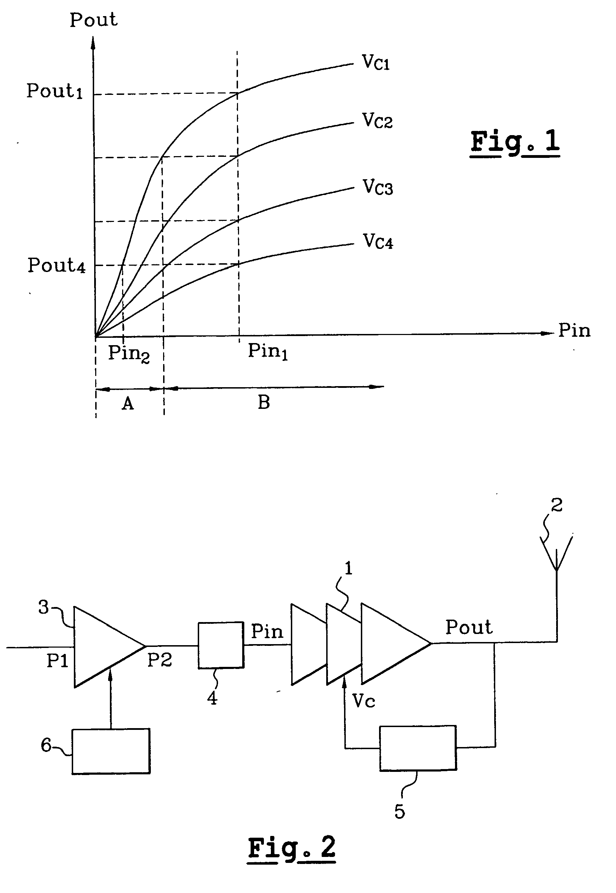

La figure 1 est un diagramme représentant la puissance de sortie Pout d'un amplificateur de puissance en fonction de sa puissance d'entrée Pin.

Le diagramme de la figure 1 montre différentes courbes correspondant à l'évolution de la puissance de sortie Pout en fonction de la puissance d'entrée Pin pour différentes valeurs de la tension de contrôle Vc (Vc₁ à Vc₄, dans l'ordre décroissant) alimentant l'amplificateur de puissance.

De manière connue, la puissance de sortie Pout d'un amplificateur de puissance est réglée en ajustant la tension de contrôle Vc pour une puissance d'entrée Pin constante.

En effet, dans le cas par exemple de terminaux de radiocommunication mobile, un préamplificateur de puissance fournit une puissance d'entrée constante Pin à un amplificateur de puissance délivrant une puissance de sortie Pout. Le niveau de la puissance de sortie Pout est ainsi ajusté, à puissance d'entrée Pin constante, par l'intermédiaire de la tension de contrôle Vc.

Le diagramme de la figure 1 présente une première zone A correspondant à un fonctionnement linéaire de l'amplificateur de puissance, et une seconde zone B correspondant à un fonctionnement non linéaire dudit amplificateur de puissance.

La zone de travail couramment utilisée dans le domaine des radiocommunications mobiles se situe aux alentours de la puissance d'entrée Pin 1 représentée figure 1. Le rendement optimal de l'amplificateur de puissance est obtenu dans cette zone, où son fonctionnement est non linéaire.

Cependant, avec cette méthode de réglage de la puissance de sortie Pout consistant à adapter la puissance de contrôle Vc, la conversion AM / AM se dégrade lorsque l'on diminue la tension de contrôle Vc pour obtenir une puissance de sortie Pout plus faible.

Le procédé selon l'invention prévoit dans ce cas une modification de la puissance d'entrée Pin lorsque la puissance de sortie Pout nécessaire devient trop faible.

Lorsque la puissance de sortie Pout requise pour le fonctionnement correct du terminal est réduite, la tension de contrôle Vc diminue tellement que la conversion AM / AM, paramètre important dans les architectures à fréquence intermédiaire nulle, se dégrade de manière trop importante.

En décalant la puissance d'entrée Pin de la valeur Pin1 à la valeur inférieure constante Pin2, la tension de contrôle Vc passe, pour une puissance de sortie Pout4 équivalente, de la valeur Vc₄ à la valeur Vc₁ nettement supérieure. L'amplificateur de puissance fonctionne alors en mode linéaire ce qui, étant donné le niveau faible de puissance de sortie, n'est pas nuisible au rendement.

La figure 2 est une représentation schématique d'un circuit apte à mettre en oeuvre le procédé de l'invention.

Ledit circuit comporte un amplificateur de puissance 1 recevant une puissance d'entrée Pin et émettant une puissance de sortie amplifiée Pout en direction d'une antenne 2 émettant les signaux radio du terminal.

La puissance d'entrée Pin provient d'un préamplificateur 3 recevant lui-même en amont une puissance d'entrée P1, issue d'un circuit connu en lui-même et non représenté. Le préamplificateur de puissance 3 délivre une puissance P2 qui, après avoir traversée un filtre 4 également connu en lui-même, devient la puissance d'entrée Pin alimentant l'amplificateur de puissance 1.

Le dispositif comporte également une boucle de contrôle de l'amplificateur de puissance 1 comportant des moyens 5 de détection de la puissance de sortie Pout et d'ajustement de la tension de contrôle Vc de l'amplificateur de puissance 1.

Ces moyens 5, connus en eux-mêmes, permettent d'adapter la puissance de sortie Pout en ajustant le niveau de la tension de contrôle Vc, et ce pour une puissance d'entrée Pin constante.

En outre, le circuit comporte des moyens 6 d'ajustement de la puissance d'entrée Pin de l'amplificateur de puissance 1.

Lesdits moyens 6, en agissant directement sur le préamplificateur de puissance 3, sont aptes en effet à abaisser la puissance de sortie P2 et donc la puissance d'entrée Pin selon le niveau de puissance de sortie Pout nécessaire.

Pour cela, le préamplificateur de puissance 3 peut être, par exemple, un préamplificateur de puissance à gain variable. Selon une autre forme de réalisation, les moyens 6 de contrôle et d'ajustement de la puissance d'entrée Pin peuvent également comprendre un atténuateur commandable de manière à ajuster la puissance d'entrée P1 du préamplificateur de puissance 3. On entend par atténuateur commandable un atténuateur commandé en tension et en courant pour lui donner une valeur variable. Ainsi, en dessous d'une puissance de sortie Pout prédéterminée et, par exemple, programmée au niveau des moyens de contrôle 6, la puissance d'entrée Pin de l'amplificateur de puissance à transistor HBT 1 est réduite permettant d'augmenter la tension de contrôle Vc de l'amplificateur de puissance 1.

Au-dessus de la valeur prédéterminée de la puissance de sortie Pout, le dispositif continue de fonctionner selon la méthode décrite en relation avec l'art antérieur. Ainsi, pour les valeurs suffisamment élevées de la puissance de sortie Pout, le niveau de cette puissance de sortie Pout est contrôlé uniquement à l'aide des moyens 5 aptes à ajuster la tension de contrôle Vc.

En procédant selon l'invention, il est possible d'utiliser des amplificateurs de puissance comportant des transistors en technologie HBT dont la compacité et le rendement sont nettement supérieurs à ceux d'amplificateurs de puissance utilisant d'autres technologies, tout en conservant une architecture à fréquence intermédiaire nulle.

De plus, l'autonomie du terminal de radiocommunication équipé d'un tel dispositif et fonctionnant selon le procédé de l'invention se trouve fortement accrue, ladite autonomie étant en relation directe avec la sollicitation de l'amplificateur de puissance 1 du terminal.

## Revendications

1. Procédé de contrôle de la puissance émise par un amplificateur de puissance (1) à transistors bipolaires à hétérojonction recevant une puissance d'entrée (Pin) et émettant une puissance de sortie amplifiée (Pout) dans une architecture à fréquence intermédiaire nulle, comportant une étape de détection de la puissance de sortie (Pout) et d'ajustement de la tension de contrôle (Vc) de l'amplificateur de puissance (1) par une boucle de contrôle comprenant des moyens (5) de détection de la puissance de sortie et d'ajustement de la tension de contrôle, **caractérisé en ce que**, tant que la puissance de sortie détectée (Pout) est supérieure à une valeur limite prédéterminée, la tension de contrôle (Vc) est ajustée par les seuls moyens (5) pour une puissance d'entrée constante, et **en ce que** lorsque la puissance de sortie détectée (Pout) est inférieure à ladite valeur limite prédéterminée, le procédé comporte une étape d'ajustement du niveau de puissance d'entrée consistant à réduire la puissance d'entrée (Pin) de façon à augmenter la tension de contrôle.

2. Emetteur en architecture à fréquence intermédiaire nulle comportant un amplificateur de puissance à transistors bipolaire à hétérojonction (1) recevant une puissance d'entrée (Pin) et émettant une puissance de sortie amplifiée (Pout) et un circuit de contrôle de la puissance émise par ledit amplificateur de puissance, comportant une boucle de contrôle comprenant des moyens (5) de détection de la puissance de sortie (Pout) et d'ajustement de la tension de contrôle (Vc) de l'amplificateur de puissance (1), **caractérisé en ce que** ledit circuit de contrôle comporte des moyens (6) d'ajustement du niveau de puissance d'entrée (Pin) de l'amplificateur de puissance (1) destinés à réduire la puissance d'entrée (Pin) de façon à augmenter la tension de contrôle lorsque la puissance de sortie détectée (Pout) est inférieure à une valeur limite prédéterminée.

3. Emetteur selon la revendication 2, **caractérisé en ce que** le circuit de contrôle comporte un préamplificateur (3) à gain variable.

4. Emetteur selon l'une des revendications 2 à 4, **caractérisé en ce que** les moyens (6) d'ajustement du niveau de puissance d'entrée (Pin) de l'amplificateur de puissance comprennent un atténuateur commandable.

5. Terminal de radiocommunication **caractérisé en ce qu'**il comporte un émetteur conforme à l'une des revendications 2 à 4.

## Claims

1. Method for controlling the power emitted by a power amplifier (1) with heterojunction bipolar transistors receiving an input power (Pin) and emitting an amplified output power (Pout) in an architecture with zero intermediate frequency, including a step for detecting the output power (Pout) and for adjusting the control voltage (Vc) of the power amplifier (1) by a control loop comprising means (5) for detecting the output power and for adjusting the control voltage, **characterized in that**, as long as the detected output power (Pout) is larger than a predetermined limiting value, the control voltage (Vc) is adjusted by the sole means (5) for constant input power, and **in that** the detected output power (Pout) is less than said predetermined limiting value, the method includes a step for adjusting the input power level, consisting of reducing the input power (Pin) in order to increase the control voltage.

2. An emitter in a zero intermediate frequency architecture including a power amplifier with heterojunction bipolar transistors (1) receiving an input power (Pin) and emitting an amplified output power (Pout) and a circuit for controlling the power emitted by said power amplifier, including a control loop comprising means (5) for detecting the output power (Pout) and for adjusting the control voltage (Vc) of the power amplifier (1), **characterized in that** said control circuit includes means (6) for adjusting the input power level (Pin) of the power amplifier (1), intended to reduce the input power (Pin) so as to increase the control voltage when the detected output power (Pout) is less than a predetermined limiting value.

3. The emitter according to claim 2, **characterized in that** the control circuit includes a variable gain preamplifier (3).

4. The emitter according to any of claims 2 to 3, **characterized in that** the means (6) for adjusting the input power level (Pin) of the power amplifier comprise a controllable attenuator.

5. A radiocommunications terminal **characterized in that** it includes an emitter according to any of claims 2 to 4.

## Patentansprüche

1. Verfahren zur Steuerung der Leistung eines Leistungsverstärkers (1) in Heteroübergangs-Bipolartransistortechnik mit einer Eingangsleistung (Pin) und einer verstärkten Ausgangsleistung (Pout) in einer Architektur mit Null Hertz Zwischenfrequenz, das einen Schritt der Erfassung der Ausgangsleistung (Pout) und der Anpassung der Steuerspannung (Vc) des Leistungsverstärkers (1) besitzt, und zwar durch einen Steuerkreis, der Erfassungseinrichtungen (5) für die Ausgangsleistung und die Anpassung der Steuerspannung besitzt, **dadurch gekennzeichnet, dass** die Steuerspannung (Vc) allein durch die Einrichtungen (5) für eine konstante Eingangsleistung angepasst wird, solange die festgestellte Ausgangsleistung (Pout) höher ist als ein vorher festgelegter Grenzwert, und dass das Verfahren einen Anpassungsschritt der Höhe der Eingangsleistung besitzt, der darin besteht, die Eingangsleistung (Pin) so zu reduzieren, dass die Steuerspannung erhöht wird, wenn die festgestellte Ausgangsleistung (Pout) unter dem vorher festgelegten Grenzwert liegt.

2. Sender in einer Architektur mit Null Hertz Zwischenfrequenz mit einem Leistungsverstärker in Heteroübergangs-Bipolartransistortechnik (1) mit einer Eingangsleistung (Pin) und einer verstärkten Ausgangsleistung (Pout) und einer Steuerungsschaltung für die Leistung, die von dem Leistungsverstärker ausgesendet wird, welche einen Steuerkreis besitzt, der Erfassungseinrichtungen (5) für die Ausgangsleistung (Pout) und die Anpassung der Steuerspannung (Vc) des Leistungsverstärkers (1) besitzt, **dadurch gekennzeichnet, dass** die Steuerschaltung Anpassungseinrichtungen (6) für die Höhe der Eingangsleistung (Pin) des Leistungsverstärkers (1) besitzt, mit denen die Eingangsleistung (Pin) derart gesenkt wird, dass sich die Steuerspannung erhöht, wenn die festgestellte Ausgangsleistung (Pout) unter einem vorher festgelegten Grenzwert liegt.

3. Sender nach Anspruch 2, **dadurch gekennzeichnet, dass** die Steuerungsschaltung einen Vorverstärker (3) mit variabler Verstärkung besitzt.

4. Sender nach einem der Ansprüche 2 bis 4, **dadurch gekennzeichnet, dass** die Einrichtungen (6) zur Anpassung der Höhe der Eingangsleistung (Pin) des Leistungsverstärkers ein steuerbares Dämpfungsglied besitzen.

5. Funkendgerät, **dadurch gekennzeichnet, dass** es einen Sender nach einem der Ansprüche 2 bis 4 besitzt.
